Europäisches Patentamt

European Patent Office

Office européen des brevets

(11) Publication number: 0 384 113 A2

# EUROPEAN PATENT APPLICATION

(21) Application number: 90100732.8

(22) Date of filing: 15.01.90

(51) Int. Cl.5: H01L 29/73, H01L 29/10

(30) Priority: 22.02.89 US 313570

(43) Date of publication of application:
29.08.90 Bulletin 90/35

(84) Designated Contracting States:
DE FR GB IT

(71) Applicant: MOTOROLA INC.
1303 East Algonquin Road
Schaumburg Illinois 60196(US)

(72) Inventor: Gaw, Craig A.
8912 N 81st Place
Scottsdale, Arizona 85258(US)
Inventor: Rode, Daniel L.
Nine Prado
St Louis, Missouri 63124(US)

(74) Representative: Holt, Michael et al
MOTOROLA European Intellectual Property
Operations Jays Close Viables Industrial
Estate
Basingstoke Hampshire RG22 4PD(GB)

(54) Multilayer base heterojunction biopolar transistor.

(57) A heterojunction bipolar transistor is made with a multilayer base (12, 13) which results in lower power loss in the base and improved current gain. Additionally, the device is compatible with single step self-aligned metallization processes. The base layer (13) nearest the emitter layer (14) has a higher doping concentration and wider bandgap energy than the layer nearest the collector (11), creating an accelerating field in the active base region (19) which improves current gain.

FIG. 1

EP 0 384 113 A2

## Background of the Invention

This invention relates, in general, to a heterojunction bipolar transistor, and more particularly, to an improved heterojunction bipolar transistor having a multilayer base structure, wherein the layer adjacent to the emitter is more heavily doped than the layer adjacent to the collector.

In the past heterojunction bipolar transistors (HBT's) have employed either a single layer base structure or a multilayer base structure. The traditional single base layer structure has high base resistance, which increases power loss in the device and increases the base-to-emitter voltage required to turn the device on. High base resistance is overcome in single layer structures by selectively doping the base region under the base electrode after epitaxy, which requires additional photolithography and diffusion processing. Post-epitaxy processing also increases defect levels and requires larger device dimensions.

A multilayer base HBT is disclosed in U. S. Patent No. 4,593,305 to Kurata et al. which employs two base layers formed of narrow band gap semiconductor material, the layer in contact with the collector having a higher impurity concentration than the layer in contact with the emitter. The base electrode makes contact with the higher doped region, which improves the series base resistance compared to the single base layer structure, yet base resistance is still undesirably high.

The above described structures and applicant's HBT structure result in a region of exposed base material between the base electrode and the emitter region. This is true of both single and multilayer base structures. Recombination of base current occurs in this region at the exposed surface, which recombines base current before it can reach the active device area and thus lowers the gain of the device. Tiwari, et al. report that surface recombination is higher in narrow band gap material than wide band gap material in "Transport and Related Properties of (Ga,Al) As/GaAs Double Heterostructure Bipolar Junction Transistors," IEEE Transactions on Electron Devices Ed-34(2), 185-98(1987). Traditional HBT's use only narrow band gap material as a base material, thus narrow band gap material is exposed at the surface, resulting in high surface recombination currents.

In the multilayer base HBT disclosed in U. S. Patent 4,593,305 a field is created between the two base layers which opposes current flow from collector to emitter. In narrow base width transistors, it is believed that this field significantly reduces current gain.

Forming a base electrode on a lightly doped p-type base layer traditionally required an alloy process to obtain an ohmic contact. The HBT described in 4,593,305 had a base doping concentration of $1 \times 10^{18}/cm^3$, which resulted in a rectifying contact before an alloy process. The alloy process results in lower product yield because of base-to-collector shorts due to base contact alloy punch-through. Also, the emitter is usually formed with a non-alloyed metallization, requiring different metals for each contact. A two metal system process which requires alloy contacts is difficult to produce with small dimensions which are required for integrated circuits and commonly used self-aligned metallization systems. Therefore it is desirable for an HBT to employ a single non-alloyed metallization for both emitter and base contacts.

Accordingly, it is an object of the present invention to provide an improved heterojunction bipolar transistor having a multilayer base.

A further object of the present invention is to provide a heterojunction bipolar transistor which can be manufactured substantially with epitaxial processes, avoiding post epitaxy diffusion processes.

Another object of the present invention is to provide a heterojunction bipolar transistor having improved low current common emitter gain performance.

A further object of the present invention to provide a heterojunction bipolar transistor which utilizes an accelerating field in the base structure to enhance current gain.

An additional object of the present invention is to provide a heterojunction bipolar transistor using a single non-alloyed metal system for both base and emitter contacts.

## Summary of the Invention

The above and other objects and advantages of the present invention are achieved by providing a heterojunction bipolar transistor with a multilayer base, wherein the base layer which contacts the emitter has a higher impurity concentration and a wider band gap than the base layer which contacts the collector.

## Brief Description of the Drawings

FIG. 1 illustrates a cross sectional view of a portion of a heterojunction bipolar transistor embodying the present invention;

FIG. 2 illustrates an equilibrium band gap diagram of the heterojunction bipolar transistor of the present invention.

Detailed Description of the Invention

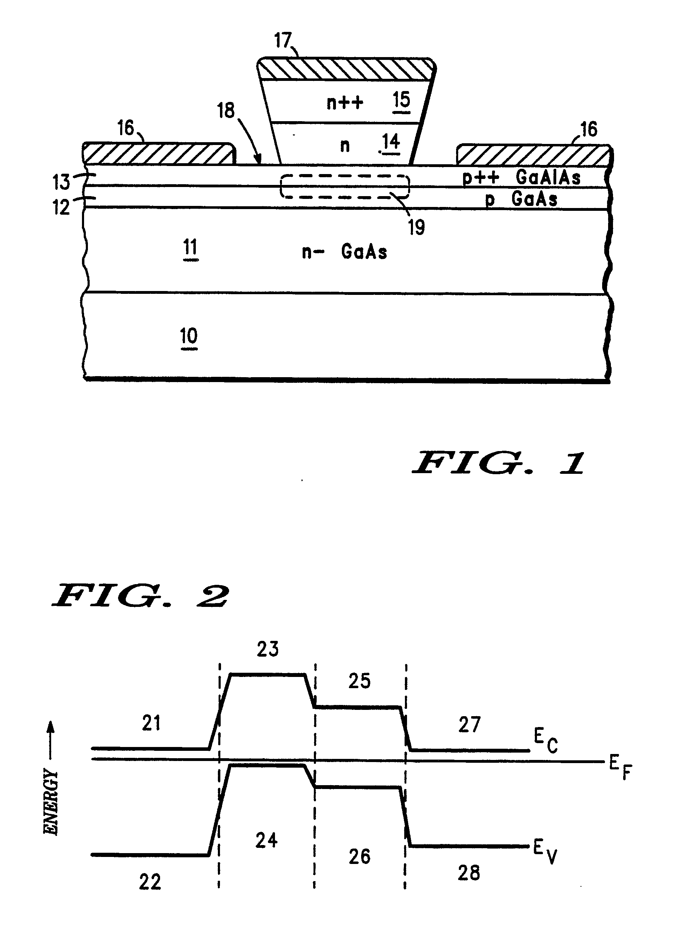

FIG. 1 illustrates in cross sectional form a portion of a heterojunction bipolar transistor (HBT) prepared in accordance with the present invention. The dopant types are illustrated as an example and not as a limitation. Also, the device can be formed of any combination of semiconductor materials with a large enough band gap difference to form a heterojunction, including many III-V compounds and Ge-Si materials. The steps in manufacturing this bipolar transistor will be described. An n-type GaAs layer 11 is used as the starting layer and serves as a collector for a resulting HBT. Layer 11 is formed by molecular beam epitaxy (MBE) or metal-organic chemical vapor deposition (MOCVD) on substrate 10. In the subsequent processes, either method may be applied. Substrate 10 may be semiconducting, semi-insulating, or insulating. A p-type GaAs layer 12 is formed by epitaxial growth techniques completely covering n-type GaAs layer 11. In a preferred embodiment p-type layer 12 forms a homojunction with n-type layer 11, but one skilled in the art could easily adjust the band gap energy of n-type layer 11 so as to form a heterojunction between p-type layer 12 and n-type layer 11. Thereafter, a p-type GaAlAs base layer 13 with relatively high impurity concentration is formed by epitaxial growth on first p-type layer 12. The multilayer base comprising layers 12 and 13 preferably has a total thickness of approximately 0.1 microns or less. An emitter layer 14 of lightly doped n-type GaAlAs is sequentially formed by the epitaxial growth method on base layer 13. A second emitter layer 15 may be formed on n-type layer 14, the second layer being more heavily doped than the first layer. Layer 15 serves to make the emitter compatible with a non-alloyed metal process, and therefore is optional if an alloyed metal is used. The resultant structure is selectively etched to leave only a central portion of the emitter, thereby exposing peripheral portion 18 of the surface of base layer 13. Base electrode 16 and emitter electrode 17 are formed by multilayer metal deposition. As an example, sequentially deposited layers of titanium, platinum, and gold, could be used for both emitter and base electrodes.

More specifically, first base layer 12 consists of a GaAs layer, with an acceptor concentration selected to meet desired device characteristics. Second base layer 13 consists approximately of a $Ga_{0.9}Al_{0.1}As$ layer with an acceptor concentration $N_a$ of at least $2 \times 10^{19}/cm^3$ and a thickness $W_b$ of approximately 0.05 microns. The n-type layer 14 consists approximately of $Ga_{0.7}Al_{0.3}As$ layer and a donor concentration selected to optimize the transistor's performance. One skilled in the art will realize that the ratio of Al to Ga in layers 13 and 14 can vary from the above ratios. It is only important that the ratios are such that layers 13 and 14 together form a heterojunction.

When voltage is applied between the base and the emitter electrodes, current flows through the lower resistance heavily doped p-type layer 13 to active base region 19, which is just below emitter layer 14. The addition of charge to active base region 19 allows current to flow from the n-type collector to the n-type emitter. It is believed that current flow is enhanced by the presence of an accelerating field generated by the wide band gap, highly doped p-type GaAlAs layer 13 on top of narrow band gap, lighter doped p-type GaAs layer 12.

FIG. 2 illustrates an equilibrium band gap diagram useful in understanding some of the advantages achieved by having a two layer base region wherein the upper layer has a higher dopant concentration and wider band gap energy than the lower layer. In general, $E_C$ is the conduction band energy and $E_V$ is the valence band energy for any material layer. $E_F$ is the Fermi level, illustrated as a reference point for the valence and conduction bands. The energy gap of a material layer is the difference $(E_V - E_C)$ between the conduction and valence bands. $E_C$ 21 and $E_V$ 22 represent the band structure of first emitter layer 14. $E_C$ 23 and $E_V$ 24 represent the band structure of second base layer 13. $E_C$ 25 and $E_V$ 26 represent the band structure of the first base layer 12. Finally, $E_C$ 27 and $E_V$ 28 represent the band structure of collector layer 11. Electron current is carried in the conduction band only when band energy $E_C$ is sufficiently close to $E_F$ to allow excess electrons to exist in the band. Likewise, hole current is carried in the valence band, only when band energy $E_V$ is close enough to $E_F$ to allow excess holes to exist in the band. In the equilibrium, or off state, p-type layers 12 and 13 carry only hole current, and n-type layers 11 and 14 carry only electron current, thus no current can flow from the emitter, through the base, to the collector. The HBT will conduct electron current from emitter to collector only when the base region conduction bands 23 and 25 are sufficiently close to the Fermi level to allow a substantial number of electrons to enter the conduction band, which occurs when the emitter-base junction is forward biased. In the present two layer base HBT, electrons which have entered base layer 13 are influenced by an accelerating field, caused by the potential difference between conduction band 23 and conduction band 25. Because band 25 is at a lower potential, the accelerating field acts to sweep electrons from layer 13 to layer 12. The magnitude of the accelerating field is a function of doping concentration differential and band gap differential between layer 12 and layer 13.

Exposed surface 18 between base electrodes 16 and emitter layer 14 is a portion of wide band gap p-type layer 13. Wide band gap GaAlAs base layer 13 suppresses electron concentration at the surface, thus lowering the surface recombination velocity and increasing the low current common emitter current gain.

The highly doped p-type base layer 13 also serves as a platform for the formation of the base electrode. By providing a highly doped surface an ohmic base electrode contact is formed without a normally required alloy process. It is common practice to form a non-alloy emitter electrode by providing a heavily doped n-type layer on top of the emitter layer. By combining this technique with the present invention, a single non-alloy metallization can be used for both emitter and base electrodes. Further, since the single metallization can be used for both electrodes, the structure is compatible with a self-aligned metallization process.

## Claims

1. A heterojunction bipolar transistor comprising: a semiconductor layer (12, 13), which serves as a base, comprising a first layer (12) of a first conductivity type formed on a collector (11) of a second conductivity type; a second layer (13) of the first conductivity type formed on the first layer (12), the second layer (13) having a higher doping concentration and wider band gap than the first layer 12, and a third layer (14) of the second conductivity type formed on at least a portion of the second layer (13), the third layer (14) serving as an emitter.

2. The heterojunction bipolar transistor of claim 1 wherein the third layer (14) is formed of a semiconductor with a wider band gap than the second layer (13), the second layer (13) forming a heterojunction with the third layer (14).

3. The heterojunction bipolar transistor of claim 1 wherein the first layer (12), the second layer (13) and the third layer (14) are formed of III-V compound semiconductor.

4. The heterojunction bipolar transistor of claim 1 further comprising a fourth layer (15) of the second conductivity type, formed on the third layer (14), with a doping concentration greater than $2 \times 10^{18}/cm^3$.

5. The HBT of claim 3 wherein the second layer (13) is formed. of approximately $Ga_{0.9}Al_{0.1}As$ with a doping concentration greater than $2 \times 10^{19}/cm^3$.

6. A heterojunction bipolar transistor provided by the steps of: providing a substrate (11) of a first conductivity type; forming a first layer (12) of a second conductivity type covering the substrate; forming a second layer (13) of the second conductivity type on the first layer, the second layer having a higher doping concentration and wider band gap than the first layer; forming a third layer (14) of the first conductivity type on at least a portion of the second layer (13), the third layer (14) having a wider band gap than the second layer (13), and the third layer (14) forming a heterojunction with the second (13); whereby the substrate (11) serves as a collector, the first and second layers (12, 13) serve as a multilayer base, and the third layer (14) serves as an emitter.

7. The heterojunction bipolar transistor of claim 6 further including the step of forming a fourth layer (15) of the first conductivity type on the third layer (14), the fourth layer (15) having a doping concentration greater than $2 \times 10^{18}/cm^3$.

8. The heterojunction bipolar transistor of claim 7 wherein the collector (11), base (12, 13), and emitter layers (14) are formed by molecular beam epitaxy.

9. The heterojunction bipolar transistor of claim 8 wherein the collector (11), base (12, 13), and emitter (14) layers are formed of a III-V compound semiconductor.

10. The heterojunction bipolar transistor of claim 7 further comprising the step of forming self-aligned electrodes (16, 17) in contact with the second layer 13 and the fourth layer 15, wherein the electrodes (16, 17) comprise a non-alloyed multilayer metallization.

*FIG. 1*

*FIG. 2*